(19) Europäisches Patentamt
European Patent Office
Office européen des brevets

(11) Veröffentlichungsnummer: **0 498 194 A1**

(12) **EUROPÄISCHE PATENTANMELDUNG**

(21) Anmeldenummer: **92100812.4**

(22) Anmeldetag: **20.01.92**

(51) Int. Cl.5: **C08F 2/50**, C08G 59/68, G03F 7/029

(30) Priorität: **08.02.91 DE 4103906**

(43) Veröffentlichungstag der Anmeldung: **12.08.92 Patentblatt 92/33**

(84) Benannte Vertragsstaaten: **CH DE FR GB IT LI NL**

(71) Anmelder: **BASF Aktiengesellschaft**
**Carl-Bosch-Strasse 38**
**W-6700 Ludwigshafen(DE)**

(72) Erfinder: **Schnabel, Wolfram, Prof. Dr.**
**Krottnauer Strasse 11**
**W-1000 Berlin 38(DE)**
Erfinder: **Yagci, Yusuf, Prof. Dr.**
**Salih Aga Sokak, Sabir Apartment**
**Yenikoey, Istanbul(TR)**
Erfinder: **Kornowski, Andreas**
**Cicerostrasse 54**
**W-1000 Berlin 31(DE)**
Erfinder: **Massonne, Klemens, Dr.**
**Oggersheimer Strasse 114**
**W-6700 Ludwigshafen(DE)**

# (54) Verfahren zur kationischen Photopolymerisation.

(57) Die Erfindung betrifft ein Verfahren zur kationischen Photopolymerisation von Epoxiden, cyclischen Ethern oder ethylenisch ungesättigten organischen Verbindungen in Gegenwart eines Photoinitiators, wobei als Photoinitiator eine Verbindung der allgemeinen Formeln (I), (II) oder (III)

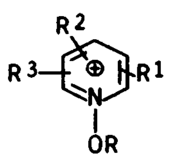 X⊖,

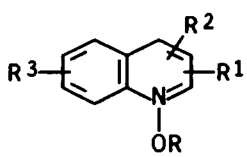 X⊖

oder

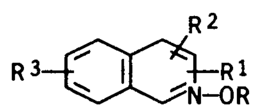

(I) (II) (III)

eingesetzt wird, worin R für Alkyl, $R^1$, $R^2$ und $R^3$ für H, Akyl, Halogen, Aryl oder $\beta$-Styryl stehen und $X^{\ominus}$ für ein nichtnukleophiles Anion steht.

EP 0 498 194 A1

Die Erfindung betrifft ein Verfahren zur kationischen Photopolymerisation von Epoxiden, cyclischen Ethern oder ethylenisch ungesättigten organischen Verbindungen in Gegenwart eines Photoinitiators.

Die strahlungsinduzierte kationische Polymerisation besitzt gegenüber der üblichen kationischen Polymerisation einige wesentliche Vorteile; so kann die Polymerisation bereits bei niedrigen Temperaturen, beispielsweise bei Raumtemperatur in Gang gebracht werden, und es können thermisch stabile Initiatoren eingesetzt werden, so daß reaktionsfähige Formulierungen lange Zeit aufbewahrt werden können.

Als wirksame Photoinitiatoren für die kationische Polymerisation sind bereits Iodoniumsalze, Sulfoniumsalze, Selenoniumsalze und Pyryliumsalze bekannt (vgl. J.V. Crivello, Adv. Polym. Sci. 62, 1 (1984), J.V. Crivello, in "UV Curing Market Corp., Norwalk, Connecticut (1978), p. 24-78 and Ledwith, Polym. Preprints ACS, 23, 323 (1982)). Abgesehen von 4-(phenylthio)-phenyl-diphenylsulfoniumhexafluorophosphat (vgl. J.V. Crivello and J.H.W. Lam, J. Polym. Sci., Polym. Chem. Ed. 18, 2677 und 2697 (1980)) absorbieren diese Substanzen kein Licht mit Wellenlängen $\lambda$ > 350 nm und sind daher von untergeordneter technischer Bedeutung.

Aufgabe der vorliegenden Erfindung ist es, neue Initiatoren für die kationische Photopolymerisation aufzuzeigen, die höhere Reaktivität aufweisen und auch für Licht mit Wellenlängen > 350 nm brauchbar sind.

Überraschenderweise gelingt dies mit bestimmten Pyridinium-, Chinolinium- und Isochinoliniumsalzen.

Gegenstand der vorliegenden Erfindung ist daher ein Verfahren zur kationischen Photopolymerisation von Epoxiden, cyclischen Ethern und ethylenisch ungesättigten organischen Verbindungen in Gegenwart eines Photoinitiators, das dadurch gekennzeichnet ist, daß als Photoinitiator eine Verbindung der allgemeinen Formeln (I), (II) oder (III)

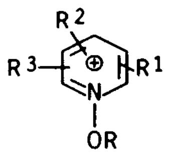 $X^{\ominus}$, 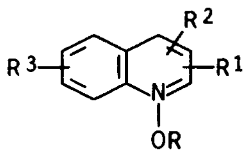 $X^{\ominus}$ oder 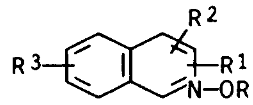

(I) (II) (III)

eingesetzt wird, worin R für Alkyl mit 1 bis 6 Kohlenstoffatomen oder Benzyl, $R^1$, $R^2$ und $R^3$ untereinander gleich oder verschieden sind und für H, Akyl mit 1 bis 4 Kohlenstoffatomen, Aryl, $\beta$-Styryl oder Halogen, wie z.B. Chlor, stehen und $X^{\ominus}$ für ein nichtnukleophiles Anion steht.

Bevorzugt sind Verbindungen der allgemeinen Formeln (I), (II) oder (III), in denen $R^1$, $R^2$ und $R^3$ für Wasserstoff oder Methyl stehen, insbesondere solche, in denen $R^1$ für Methyl oder Phenyl in ortho- oder para-Stellung zum N und $R^2$ und $R^3$ für H stehen.

Bevorzugt sind ferner solche Verbindungen der allgemeinen Formeln (I), (II) oder (III), in denen R für Methyl oder Ethyl, insbesondere für Ethyl steht.

Als nichtnukleophile Anionen $X^{\ominus}$ kommen z.B. in Frage $ClO_4^{\ominus}$, $BF_4^{\ominus}$, $AsF_6^{\ominus}$, $SbF_6^{\ominus}$, $PF_6^{\ominus}$, $CH_3SO_3^{\ominus}$, $CF_3SO_3^{\ominus}$ und Toluolsulfonat.

Die erfindungsgemäß einzusetzenden Verbindungen der allgemeinen Formeln (I), (II) und (III) lassen sich analog der von C. Reichardt in Chem. Ber. 99, 1769 (1966) beschriebenen Methode herstellen, also z.B. das N-Ethoxy-2-methylpyridiniumhexafluorophosphat (Fp.: 89 °C) durch Umsetzung von Triethyloxoniumhexafluorophosphat mit 2-Methylpyridin-N-oxid in trockenem Chloroform und Umkristallisieren aus Ethanol, bzw. das N-Ethoxy-4-phenylpyridiniumhexafluorophosphat (Fp.: 131 °C; Überprüfung durch Elementaranalyse und $^1$H-NMR) durch Umsetzung von Triethyloxoniumhexafluorophosphatmit 4-Phenylpyridin-N-oxid, bzw. das N-Ethoxy-isochinoliniumhexafluorophosphat (Fp.: 106, 7 °C; Überprüfung durch Elementaranalyse und $^1$H-NMR) durch Umsetzung von Triethyloxoniumhexafluorophosphat mit Isochinolin-N-oxid.

Die als Ausgangsstoffe zur Herstellung der erfindungsgemäß zu verwendenden Pyridinium-, Chinolinium- und Isochinoliniumsalze dienenden Pydridinoxide, (Iso)chinolinoxide und Triethyloxoniumsalze sind handelsübliche Produkte (beispielsweise von der Fa. Aldrich erhältlich).

Die Maxima der Absorbtionsspektren liegen für N-Ethoxy-2-methylpyridiniumhexafluorophosphat bei 265 nm, N-Ethoxy-4-phenylpyridinium-hexafluorophosphat bei 310 nm und N-Ethoxy-isochinolinium-hexafluorophosphat bei 285 und 337 nm, die beiden zuletzt genannten absorbieren Licht von Wellenlängen $\lambda$ > 350 nm.

Beispiele weiterer erfindungsgemäßen Photoinitiatoren für die kationische Photopolymerisation sind: N-Methoxy-2-methylpyridinium-hexafluorophoshat, N-Isopropoxy-2-methylpyridinium-hexafluorophosphat, N-Isobutoxy-2-methylpyridinium-hexafluorophosphat, N-tert.-butoxy-2-methylpyridinium-hexafluorophosphat, N-Benzyloxy-2-methylpyridinium-hexafluorophosphat, N-Ethoxy-2-ethylpyridinium-hexafluorophosphat, N-Ethoxy-2-β-styrylpyridinium-hexafluorophosphat, N-Ethoxy-2-methyl-chinolinium-hexafluorophosphat, N-Ethoxy-2-methylisochinolinium-hexafluorophosphat.

Diese Photoinitiatoren können in Mengen von 0,1 bis 15, vorzugsweise 0,5 bis 10 Gew.-%, bezogen auf die Gesamtmenge der polymerisierbaren Epoxide, cyclischen Ether und ethylenisch ungesättigten organischen Verbindungen, eingesetzt werden.

Ein Vorteil der für das erfindungsgemäße Verfahren einzusetzenden Photoinitiatorsysteme besteht u.a. auch darin, daß sie nach dem Bestrahlen praktisch geruchsneutral sind.

Zum erfindungsgemäßen Verfahren ist im einzelnen noch folgendes auszuführen.

Als erfindungsgemäß zu polymerisierende Monomere kommen Epoxide, cyclische Ether und ethylenisch ungesättigte organische Verbindungen in Frage.

Beispiele für Epoxide (Oxirane) können sein: Mono-1,2-epoxide, wie Epichlorhydrin, Propylenoxid, Cyclohexenoxid oder ein Glycidether eines einwertigen Alkohols oder Phenols, wie n-Butylglycidylether oder Phenylglycidylether, ein Glycidylester, wie Glycidylacrylat oder Glycidylmethacrylat, vorzugsweise ein Epoxidharz, insbesondere ein solches, das mindestens eine direkt an ein Sauerstoffatom gebundene Gruppe der Formel

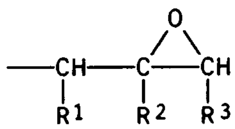

enthält, worin entweder $R^1$ und $R^3$ je ein Wasserstoffatom darstellen, in welchem Fall $R^2$ ein Wasserstoffatom oder eine Methylgruppe bedeuten, oder $R^1$ und $R^3$ zusammen $-CH_2CH_2-$ darstellen, in welchem Fall $R^2$ ein Wasserstoffatom bedeutet.

Als Beispiele für solche Harze seien Polyglycidyl- und Poly-(β-methylglycidyl)-ester genannt, die man durch Umsetzung einer zwei oder mehr Carbonsäuregruppen pro Molekül enthaltenden Verbindung mit Epichlorhydrin, Glycerin-dichlorhydrin oder β-Methylepichlorhydrin in Gegenwart von Alkali erhalten kann. Solche Polyglycidylester können sich von aliphatischen Polycarbonsäuren, z.B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäuren wie Tetrahydrophthalsäure, 4-Methyltetrahydrophthalsäure, Hexahydrophthalsäure und 4-Methylhexahydrophthalsäure und von aromatischen Polycarbonsäuren, wie Phthalsäure, Isophthalsäure und Terephthalsäure ableiten. Weitere geeignete Polyglycidylester sind durch Polymerisation der Glycidylester von olefinisch ungesättigten Carbonsäuren, insbesondere Glycidylacrylat und Glycidylmethacrylat, erhältlich.

Weitere Beispiele sind Polyglycidyl- und Poly-(β-methylglycidyl)-ether, die durch Umsetzung einer mindestens zwei freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung erhältlich sind. Diese Ether lassen sich mit Poly-(epichlorhydrin) aus acyclischen Alkoholen wie Ethylenglykol, Diethylenglykol und höheren Poly-(oxyethylen)-glykolen, Propan-1,2-diol und Poly-(oxypropylen)-glykolen, Propan-1,3-diol, Poly-(oxytetramethylen)-glykolen, Pentan-1,5-diol, Hexan-2,4,6-triol, Glycerin, 1,1,1-Trimethylolpropan, Pentaerythrit und Sorbit, aus cycloaliphatischen Alkoholen wie Resorcit, Chinit, Bis-(4-hydroxycyclohexyl)-methan, 2,2-Bis-(4-hydroxycyclohexyl)-propan und 1,1-Bis-(hydroxymethyl)-cyclohexen-3, sowie aus Alkoholen mit aromatischen Kernen, wie N,N-Bis-(2-hydroxyethyl)-anilin und p,p'-Bis-(2-hydroxyethylamino)-diphenylmethan, herstellen. Man kann sie ferner aus einkernigen Phenolen wie Bis-(4-hydroxyphenyl)-methan (sonst als Bisphenol F bekannt), 4,4'-Dihydroxyphenyl, Bis-(4-hydroxyphenyl)-sulfon, 1,1,2,2-Tetrakis-(4-hydroxyphenyl)-ethan, 2,2-Bis-(4-hydroxyphenyl)-propan (sonst als Bisphenol A bekannt) und 2,2-Bis(3,5-dibrom-4-hydroxyphenyl)-propan, sowie aus Aldehyden wie Formaldehyd, Acetaldehyd, Chloral und Furfurol mit Phenol selbst und durch Chloratome oder Alkylgruppen mit jeweils bis zu neun Kohlenstoffatomen ringsubstituiertes Phenol, wie 4-Chlorphenol, 2-Methylphenol und 4-tert.-Butylphenol, gebildeten Novolaken herstellen.

Poly-(N-glycidyl)-verbindungen lassen sich ebenfalls verwenden, beispielsweise N-Glycidylderivate von Aminen wie Anilin, n-Butylamin, Bis-(4-aminophenyl)-methan und Bis-(4-methylaminophenyl)-methan, Triglycidylisocyanurat sowie N,N'-Diglycidylderivate von cyclischen Alkylenharnstoffen wie Ethylenharnstoff und 1,3-Propylenharnstoff und Hydantoinen wie 5,5'-Dimethylhydantoin.

Ebenfalls kann man Poly-(S-glycidyl)-verbindungen einsetzen, z.B. Di-(S-glycidyl)-derivate von Dithiolen

wie Ethan-1,2-dithiol und Bis-(4-mercaptomethylphenyl)-ether.

Beispiele für Epoxidharze mit Gruppen der obengenannten Formel, worin $R^1$ und $R^3$ zusammen eine $-CH_2CH_2$-Gruppe bedeuten, sind Bis-(2,3-epoxycyclopentyl)-ether, 2,3-Epoxycyclopentyl-glycidylether und 1,2-Bis-2,3-epoxycyclopentyloxy)-ethan.

In Betracht kommen auch Epoxidharze, in denen die 1,2-Epoxidgruppen an Heteroatome verschiedener Art gebunden sind, z.B. der Glycidylether/Glycidylester der Salicylsäure.

Ebenfalls verwendbar sind Epoxidharze, in denen einige oder sämtliche Epoxidgruppen mittelständig sind, wie Vinylcyclohexenoid, Vinylcyclohexendioxid, Limonendioxid, Dicyclopentadiendioxid, 4-Oxatetracyclo-[6.2.1.$0^{2,7}$.$0^{3,5}$]undecyl-9-glycidylether, 1,2-Bis-(4-oxatetracyclo-[6.2.1.$0^{2,7}$.$0^{3,5}$]undecyl-9-oxy)-ethan, der 3,4-Epoxycyclohexylmethylester der 3',4'-Epoxicyclohexancarbonsäure sowie dessen 6,6'-Dimethylderivat, der Bis-(3,4-epoxicyclohexancarbonsäureester) des Ethylenglykols, 3-(3,4-epoxicyclohexyl)-8,9-epoxi-2,4-dioxaspiro[5.5]-undecan sowie epoxidierte Butadiene oder Copolymere des Butadiens mit Ethylenverbindungen wie Styrol und Vinylacetat.

Gewünschtenfalls kann man Gemische von Epoxiden oder Epoxidharzgemische verwenden.

Besonders bevorzugte, bei dem erfindungsgemäßen Verfahren verwendete, gegebenenfalls vorverlängerte Epoxidharze sind die Diglycidylether von zweiwertigen Phenolen, wie 2,2-Bis-(4-hydroxyphenyl)-propan und Bis-(4-hydroxyphenyl)-methan, und von zweiwertigen aliphatischen Alkoholen, wie Butan-1,4-diol.

Gewünschtenfalls kann man das Epoxidharz einer Mischhärtung mit einem mehrwertigen Alkohol, d.h. einer Verbindung mit mindestens zwei alkoholischen, vorzugsweise primären Hydroxylgruppen im Molekül, unterwerfen. Vorzugsweise liegt der mehrwertige Alkohol in genügender Menge vor, um 0,5 bis 1,5, insbesondere 0,75 bis 1,25, alkoholische Hydroxylgruppen pro 1,2-Epoxidgruppe des Epoxidharzes zu liefern. Der mehrwertige Alkohol enthält vorzugsweise außer den alkoholischen Hydroxylgruppen nur Kohlen-, Wasserstoff- und gegebenenfalls als Ethersauerstoff oder Acetal- oder Carbonylgruppen vorhandene Sauerstoff- sowie Halogenatome. Ferner besitzt der mehrwertige Alkohol vorzugsweise ein Molekulargewicht von mindestens 100 und insbesondere höher als 1000. Geeignete mehrwertige Alkohole sind beispielsweise Poly-(oxyethylen)-glykole, Poly-(oxypropylen)-glykole, Poly-(oxytetramethylen)-glykole, Polyepichlorhydrine, Poly-(oxyethylen)-, Poly-(oxypropylen)-, bzw. Poly-(oxyetetramethylen)-triole, die durch Polymerisation von Ethylenoxid, Propylenoxid bzw. Tetrahydrofuran in Gegenwart von Glycerin oder 1,1,1-Trimethylolpropan erhältlich sind, Polycaprolactone mit Hydroxylendgruppen, Copolymere des Styrols mit Allylalkohol, Polyvinylalkohole, Hydroxypropylcellulose, hydroxyhaltige Polyvinylacetale und Teilester der Cellulose, z.B. ein Celluloseacetatbutyrat.

Ein einfaches Beispiel für einen geeigneten cyclischen Ether ist das Tetrahydrofuran.

Zur kationischen Photopolymerisation nach dem erfindungsgemäßen Verfahren eignen sich auch ethylenisch ungesättigte organische Verbindungen, die kationisch polymerisierbar sind, wie Vinylaromaten, wie z.B. Styrol, p-Methylstyrol, p-Methoxystyrol, $\alpha$-Methylstyrol, sowie Vinylether.

Vinylether, die nach dem erfindungsgemäßen Verfahren kationisch polymerisiert werden können, sind Vinylether von aliphatischen einwertigen Alkoholen mit 1 bis 12, vorzugsweise 1 bis 4 Kohlenstoffatomen sowie der 3,4-Dihydro-2H-pyranyl-(2)methylester der 3,4-Dihydro-2H-pyran-2-carbonsäure, Isobutylvinylether, Methylvinylether, Trimethylolpropan-trivinylether, Glycerintrivinylether, Triethylenglycoldivinylether, 1,4-Cyclohexandimethanoldivinylether, die Vinylether und Divinylether von Ethylenglykol, Butandiol, Tetraethylenglykol und Poly-(oxyethylenglykolen) und cyclische Vinylether mit mindestens zwei cyclischen Vinylethergruppen, die jeweils einen Teil eines 3,4-Dihydro-2H-pyrankerns bilden, wie der 3,4-Dihydro-2H-pyranyl-(2)-methylester der 3,4-Dihydro-2H-pyran-2-carbonsäure und dessen Präpolymere. Sogenannte oligomere Vinylether, wie das Reaktionsprodukt eines Umsetzungsproduktes aus Trimethylolpropan und Toluyolendiisocyanat (Molverhältnis 1:3) mit Cyclohexan-1,4-dimethylolmonovinylether (im Molverhältnis 1:3) sowie deren Gemische mit anderen Vinylethern, insbesondere polyfunktionellen Vinylethern, wie Z.B. Tetraethylenglykoldivinylether eigenen sich ebenso sehr vorteilhaft für das erfindungsgemäße Verfahren.

Die Monomeren können vor der Polymerisation zweckmäßigerweise gereinigt werden, beispielsweise Cyclohexenoxid durch Abdestillieren über $CaH_2$ unter vermindertem Druck, Tetrahydrofuran nach Lagerung über NaOH durch Abdestillieren über $CaH_2$, bzw. die Vinylether, wie z.B. N-Butylvinylether durch Waschen mit wäßriger Natronlauge (ca. 10 %ig) und Wasser, Trocknen mit $CaCl_2$ und $Na_2SO_4$ und Abdestillieren über $CaH_2$.

Bei der Durchführung des erfindungsgemäßen Verfahrens lassen sich als Verdünnungsmittel zweckmäßigerweise inerte organische Lösungsmittel, wie Halogenwasserstoffe, z.B. Methylenchlorid, Chloroform, Tetrachlorkohlenstoff oder Trichlorethylen, Ether, wie Diisopropylether, Ethylenglykoldimethylether oder Diethylenglykoldimethylether, Ester, wie n-Butylacetat oder Ethylenglykolmonomethyletheracetat, Gemische dieser Lösungsmittel untereinander sowie mit üblichen Lösungsmitteln auf Kohlenwasserstoffbasis, wie

Cyclohexan oder Toluol mitverwenden.

Beim Photopolymerisationsvorgang verwendet man vorzugsweise aktinische Strahlung einer Wellenlänge von 200 bis 600 nm. Als aktinische Strahlungsquellen eignen sich unter anderem Kohlelichtbögen, Quecksilberdampflichtbögen, Leuchtröhren mit ultraviolettes Licht ausstrahlenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung erforderliche Zeit hängt von verschiedenen Faktoren ab, unter anderem beispielsweise dem jeweils verwendeten polymerisierbaren Substrat, der Art der Lichtquelle und deren Abstand vom bestrahlten Material. Der mit Photopolymerisationsmethoden vertraute Fachmann kann die geeigneten Zeiten leicht bestimmen. Wenn es erforderlich ist, daß das so photopolymerisierte Produkt beim Erhitzen mit einem eingemischten Heißhärter noch härtbar ist, dann muß die Bestrahlung natürlich bei einer Temperatur unterhalb derjenigen, bei der weitgehenden Heißhärtung des photopolymerisierten Produkts durch den Heißhärter eintreten würde, erfolgen.

Die erfindungsgemäßen Mischungen sind als Oberflächenbeschichtungen verwendbar. Man kann sie, vorzugsweise als Flüssigkeit, auf ein Substrat wie Stahl, Aluminium, Kupfer, Papier oder Holz aufbringen und bestrahlen. Polymerisiert man einen Teil der Beschichtung, wie bei Bestrahlung durch eine Maske hindurch, so kann man die unbelichteten Stellen mit einem Lösungsmittel waschen, um unpolymerisierte Anteile zu entfernen, während die photopolymerisierten, unlöslichen Anteile an Ort und Stelle verbleiben. Die erfindungsgemäßen Zusammensetzungen sind somit bei der Herstellung von Druckplatten und gedruckten Schaltungen verwendbar.

Die Mischungen lassen sich auch als Klebstoffe verwenden. Eine Schicht der Zusammensetzung kann zwischen zwei Oberflächen von Gegenständen, von denen mindestens einer für aktinische Strahlung durchlässig ist, z.B. Glas, eingebracht werden, und der Aufbau wird dann bestrahlt und gewünschtenfalls erhitzt, um die Polymerisation zu vervollständigen.

Die Mischungen sind ferner bei der Herstellung von faserverstärkten Verbundstoffen, einschließlich Plattenpressmassen, verwendbar.

Die in den Beispielen genannten Teile und Prozente sind, soweit nicht anders angegeben, Gewichtsteile bzw. Gewichtsprozente.

Beispiel 1

Eine Lösung von n-Butylvinylether (7,7 mol/l) in Dichlormethan wurde mit $1 \cdot 10^{-3}$ mol/l N-Ethoxyisochinoliniumhexafluorophosphat vermischt und unter Durchleiten von Argon mit einer Xenonlampe (Osram XBO 450 W) mit Monochromator ($\lambda$ > 350 nm bzw. $\lambda_{inc}$ = 366 nm) 1 min lang bestrahlt. Das so erhaltene Polymere wurde mit Methanol ausgefällt und getrocknet (Ausbeute: 62 % d. Th.). Die Bestimmung des mittleren Molekulargewichts des Poly-n-butyl-vinylethers mittels Lichtstreuung (Kleinwinkelstreuung ($\lambda_{obs}$ = 632 nm) unter Verwendung eines Chromatix-Gerätes KMX-6) ergab 9000.

Beispiel 2

Eine Lösung von 3,4-Epoxycyclohexyl(methyl)-3',4'epoxycyclohexancarboxylat (2,0 mol/l) in Dichlormethan wurde mit $1 \cdot 10^{-2}$ mol/l N-Ethoxyisochinoliniumhexafluorophosphat vermischt und unter Durchleiten von Argon mit der in Beispiel 1 beschriebenen Xenonlampe 120 min bestrahlt. Es wurde ein vernetztes Produkt erhalten.

Beispiel 3

Eine Lösung von Cyclohexenoxid (5,9 mol/l) in Dichlormethan wurde mit $5 \cdot 10^{-3}$ mol/l N-Ethoxyisochinoliniumhexafluorophosphat vermischt und unter Durchleiten von Argon mit der in Beispiel 1 beschriebenen Xenonlampe 5 min lang bestrahlt. Nach der Aufarbeitung entsprechend Beispiel 1 wurde in einer Ausbeute von 46 % der Theorie ein Polymer mit einem mittleren Molekulargewicht (Bestimmung durch Lichtstreuung) von 12 000 erhalten.

Beispiel 4

Eine Lösung von Cyclohexenoxid (5,9 mol/l) in Dichlormethan wurde mit jeweils 5 • 10-3 mol/l der in der Tabelle aufgeführten Photoinitiatoren vermischt und unter Durchleiten von Argon mit einer Xenonlampe ($\lambda_{inc}$ = 366 nm) entsprechend Beispiel 1 180 bzw. 120 min lang bestrahlt. Die Ergebnisse sind in Tabelle 1

aufgeführt.

Tabelle 1:

| Initiator | O.D. bei 366 nm | Bestrahlungszeit [min] | Umsatz Gew.-% | mittleres Molekulargewicht |
|---|---|---|---|---|
| Triphenylsulfonium-hexafluorophosphat (= Vergleich) | 0 | 180 | 0 | - |
| Diphenyliodonium-hexafluorophosphat (= Vergleich) | 0,023 | 180 | 0,9 | |
| N-Ethoxy-4-phenylpyridiniumhexafluorophosphat (erfindungsgemäß) | 0,38 | 120 | 2,8 | $1,1 \cdot 10^4$ |
| N-Ethoxyisochinolinium-hexafluorophosphat (erfindungsgemäß) | 0,85 | 120 | 47,8 | $2,2 \cdot 10^4$ |

Beispiel 5

Eine Mischung aus

| | | |
|---|---|---|
| 1,35 | Teilen oligomerem Vinylether (oligomerer Vinylether = das Reaktionsprodukt eines Umsetzungsproduktes aus Trimethylolpropan und Toluyolendiisocyanat (Molverhältnis 1:3) mit Cyclohexan-1,4-dimethylolmonovinylether (im Molverhältnis 1:3)) |
| 2,35 | Teilen Tetraethylenglykoldivinylether, |
| 1,00 | Teilen n-Butylacetat und |
| 0,075 | Teilen jeweils eines der in Tabelle 2 aufgeführten Photoinitiatoren |

wird in einem lichtundurchlässigen Glas ca. 10 min gerührt, bis eine homogene Mischung entstanden ist. Ein Teil der Mischung wird so zwischen zwei plangeschliffene NaCl-Platten gebracht, daß ein zusammenhängender Film einer Schichtdicke von ca. 15 µm erhalten wird. Von dieser Schicht wird ein IR-Spektrum im Bereich von 2000 $cm^{-1}$ bis 800 $cm^{-1}$ aufgenommen (IR-Spektrometer 881 der Fa. Perkin Elmer). Die Schicht wird mit einer 200 W Hg-Höchstdrucklampe in einem Abstand von 30 cm bestrahlt, bis die hinter der Probe gemessene durchgestrahlte Energie 200 mJ beträgt. Von der bestrahlten Schicht wird erneut ein IR-Spektrum aufgenommen.

Als Initiatorkennzahl (= IKZ) wird die Änderung der für die Vinylethergruppen charakteristischen IR-Banden (gemessen in % Transmission) bestimmt.

$$\begin{aligned} IKZ = {} & \Delta T\ (1620\ cm^{-1}) - \Delta T\ (1740\ cm^{-1}) + \Delta T\ (1320\ cm^{-1}) \\ & - \Delta T\ (1240\ cm^{-1}) + \Delta T\ (1200\ cm^{-1}) - \Delta T\ (1240\ cm^{-1}) \\ & + \Delta T\ (980\ cm^{-1}) + \Delta T\ (960\ cm^{-1}) + \Delta T\ (820\ cm^{-1}) \end{aligned}$$

Die Meßergebnisse sind als Mittelwert aus drei unabhängigen Bestimmungen in Tabelle 2 eingetragen.

Tabelle 2

| Nr. | Initiator | IKZ |
|---|---|---|
| 1 | UVI 6974 (von Fa. UCC) | 169 |
| 2 | UVI 6990 (von Fa. UCC) | 171 |
| 3 | Degacure® KI/85 B (von Fa. Degussa) | 173 |
| 4 | Triphenylsulfoniumhexafluorophosphat | 177 |
| 5 | Triphenylsulfoniumhexafluoroarsenat | 180 |
| 6 | Diphenyljodoniumhexafluorophosphat | 146 |
| 7 | Diphenyljodoniumhexafluoroarsenat | 152 |
| 8 | Diphenyljodoniumtetrafluoroborat | 172 |
| 9 | N-Ethoxy-4-phenylpyridiniumhexafluorophosphat (erfindungsgemäß) | 191 |
| 10 | N-Ethoxyisochinoliniumhexafluorophosphat (erfindungsgemäß) | 197 |

Die unter Nr. 1 bis 8 zum Vergleich angeführten Photoinitiatoren repräsentieren den Stand der Technik.

## Patentansprüche

1. Verfahren zur kationischen Photopolymerisation von Epoxiden, cyclischen Ethern oder ethylenisch ungesättigten organischen Verbindungen in Gegenwart eines Photoinitiators, dadurch gekennzeichnet, daß als Photoinitiator eine Verbindung der allgemeinen Formeln (I), (II) oder (III)

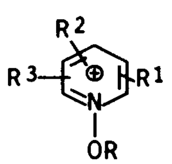 X⊖, 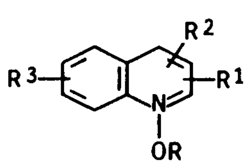 X⊖ oder 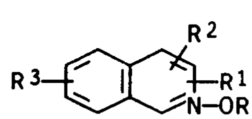

(I) (II) (III)

eingesetzt wird, worin R für Alkyl mit 1 bis 6 Kohlenstoffatomen oder Benzyl, $R^1$, $R^2$ und $R^3$

untereinander gleich oder verschieden sind und für H, Akyl mit 1 bis 4 Kohlenstoffatomen, Halogen, Aryl oder β-Styryl stehen und $X^{\ominus}$ für ein nichtnukleophiles Anion steht.

**2.** Verfahren nach Anspruch 1, dadurch gekennzeichnet, daß in den allgemeinen Formeln (I), (II) und (III) $R^1$, $R^2$ und $R^3$ für Wasserstoff oder Methyl stehen.

**3.** Verfahren nach Anspruch 1 oder 2, dadurch gekennzeichnet, daß in den allgemeinen Formeln (I), (II) und (III) R für Methyl oder Ethyl steht.

**4.** Verfahren nach Anspruch 1, dadurch gekennzeichnet, daß in den Verbindungen der allgemeinen Formeln (I), (II) oder (III) $R^1$ in ortho- oder para-Stellung zum N für Alkyl mit 1 bis 4 Kohlenstoffatomen, für Phenyl oder für β-Styryl steht.

Europäisches Patentamt

# EUROPÄISCHER RECHERCHENBERICHT

Nummer der Anmeldung

EP 92 10 0812

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 314 619 (CIBA-GEIGY)<br>--- | | C08F2/50<br>C08G59/68<br>G03F7/029 |
| A | DE-A-2 750 123 (BASF)<br>--- | | |
| P,X | EP-A-0 441 232 (BASF)<br>* Anspruch 1 *<br>----- | 1-4 | |
| | | | **RECHERCHIERTE SACHGEBIETE (Int. Cl.5)** |
| | | | C08F<br>G03F<br>C08G |

Der vorliegende Recherchenbericht wurde für alle Patentansprüche erstellt

| Recherchenort | Abschlußdatum der Recherche | Prüfer |
|---|---|---|
| DEN HAAG | 14 MAI 1992 | CAUWENBERG C.L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)